# EUROPEAN PATENT APPLICATION

(11) **EP 0 913 865 A2**
(43) Date of publication of application: **06.05.1999**
(21) Application number: 98308572.1
(22) Date of filing: 20.10.1998
(51) Int. Cl.: H01L 23/498

(54) **Low noise ball grid array package**

(30) Priority: 30.10.1997 US 960735
(71) Applicant: Hewlett-Packard Company, Palo Alto, California 94304 (US)
(72) Inventor: Humphrey, Tamio J., Corvallis, OR 97330 (US); Hudson, James C., Boise, ID 83703 (US)
(74) Representative: Colgan, Stephen James

(57) **Abstract**

A low inductance integrated circuit package (10) such as a ball grid array. In order to reduce electromagnetic interference (EMI) caused by an integrated circuit mounted in the package, a filtering device (30) is coupled to at least one of the power and ground lines (40,42) that feeds the integrated circuit. In a preferred embodiment, a plurality of filtering capacitors (30) are coupled between the power and ground lines (40,42) in or near the cavity (20) of the package.

## Description

### FIELD OF THE INVENTION

The present invention relates to ball grid arrays and more specifically to reducing undesired noise therein.

### BACKGROUND OF THE INVENTION

Ball grid arrays (BGA) and the like are a known type of integrated circuit package. A typical ball grid array includes a platform having a die attachment region provided thereon. The area in which the die attachment region is located is generally referred to as the cavity while the peripheral area around the cavity is often referred to as the border. A plurality of contact pads are usually placed along the edge of the die attachment area and the contact pads are connected by conductors internal to the platform to conductive "balls" on the backside (underside when mounted) of the platform. These conductive balls are normally arranged in a grid pattern, hence the name ball grid array. The conductive balls form a low inductance electrical connection between the ball grid array package and a printed circuit board.

Electromagnetic interference (EMI), commonly referred to as "noise", is a problem associated with small scale, high-speed circuits, including those packaged in ball grid arrays. Prior art attempts to reduce EMI in ball grid array environments have included placing capacitors on the printed circuit board to which the ball grid array is attached and forming capacitors on the backside of the platform. With respect to printed circuit board mounted capacitor arrangements, a disadvantage of this arrangement is that the capacitors are located far from the EMI source (the packaged integrated circuits) and hence undesirable noise is fairly widely distributed before the capacitors can attempt noise suppression. With respect to backside capacitor arrangements, a disadvantage of these arrangements is that their fabrication tends to be complicated and expensive and raising the height of the ball grid array may be required to accommodate their size.

### SUMMARY OF THE INVENTION

Accordingly, it is an object of the present invention to provide a ball grid array that is capable of on-board reduction of EMI and related noise at a point close to the source of that noise.

It is another object of the present invention to provide a ball grid array that has a noise reduction mechanism in the cavity thereof.

It is also an object of the present invention to provide a ball grid array that suppresses EMI and related noise and is economical to produce.

These and related objects of the present invention are achieved by use of a ball grid array as described herein.

In one embodiment, the present invention includes a platform having a plurality of low inductance mounting conductors formed on a first side thereof; a cavity formed on a second side of said platform and including a die attachment region; a plurality of electrical contacts formed in said cavity proximate said die attachment region for receiving the pads of an integrated circuit mounted at said die attachment region, at least some of said electrical contacts being coupled by conductors in said platform to some of said mounting conductors; a power line coupled to at least one of said electrical contacts; a ground line coupled to at least another of said electrical contacts; and means provided on said second side of said platform and coupled to at least one of said power and ground lines for reducing EMI generated by an integrated circuit mounted at said die attachment region. In a preferred embodiment, the EMI reducing means are coupled between the power and ground line and include a filtering capacitor. The EMI reducing means are also preferably surface mounted proximate the die attachment region.

In another embodiment, the present invention includes a platform having a plurality of low inductance mounting conductors formed on a bottom side thereof; a cavity formed on a top side of said platform and including a die attachment region; a power line formed in said cavity for providing power to an integrated circuit mounted in said cavity; a ground line formed in said cavity for providing ground to an integrated circuit mounted in said cavity; and a filtering device coupled to at least one of said power and ground lines for filtering noise generated by an integrated circuit mounted at said die attachment region.

The attainment of the foregoing and related advantages and features of the invention should be more readily apparent to those skilled in the art, after review of the following more detailed description of the invention taken together with the drawings.

### BRIEF DESCRIPTION OF THE DRAWINGS

Fig. 1 is a perspective view of a ball grid array in accordance with the present invention.

Fig. 2 is a plan view of conductors in the cavity of the ball grid array of Fig. 1 in accordance with the present invention.

### DETAILED DESCRIPTTON

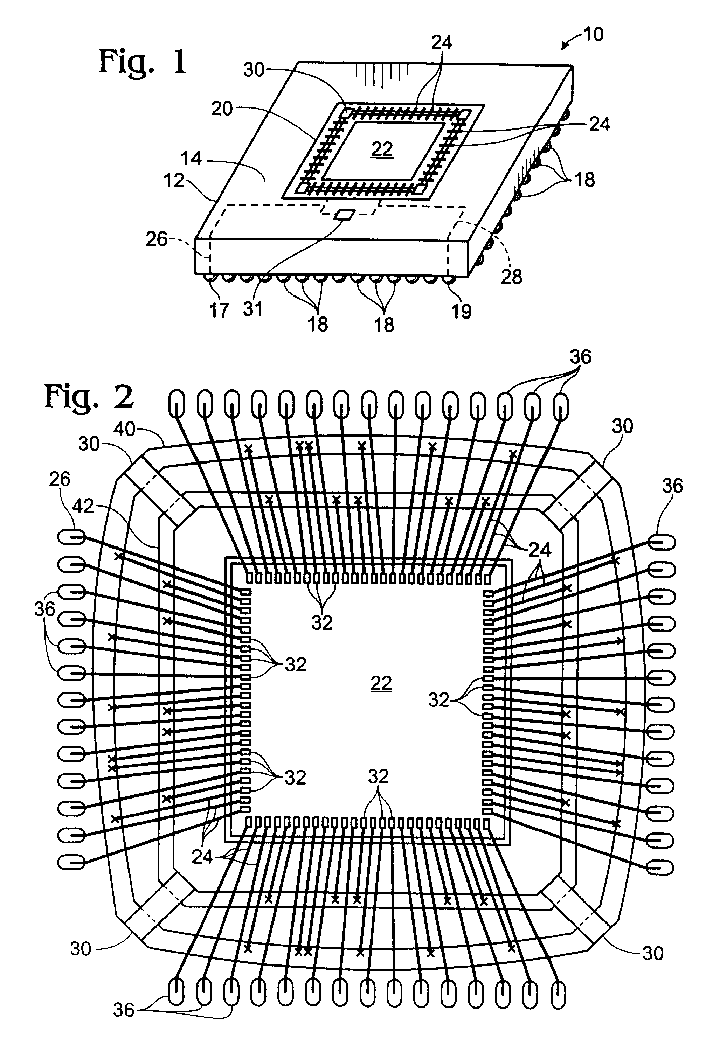

Referring to Fig. 1, a perspective view of a ball grid array 10 in accordance with the present invention is shown. Ball grid array 10 possesses a platform 12, a border 14 and a cavity 20. Cavity 20 includes a die mounting region 22 where one or more integrated circuits (not shown) or related devices are positioned.

Cavity 20 also includes a plurality of conductive traces 24 (shown in more detail in Fig. 2) to which pads of an integrated circuit are attached. The attachment of an integrated circuit to conductive traces in a cavity is known in the art. Conductive traces 24 are connected by conductors within ball grid array 10 to surface mount low inductance conducting bumps or balls 18. The conductive balls are preferably arranged in a grid pattern on the bottom of platform 12 and are preferably made of solder or conductive epoxy or a like conductive material. The layout and formation of conductors between signal traces 24 and conductive balls 17-19 is known in the art.

Fig. 1 further illustrates a power line 26 that is fed through ball 17 and a ground line 28 that is fed through ball 19. Power line 26 and ground line 28 are respectively connected to power and ground loops 40,42 in the cavity. A plurality of filter capacitors 30 are preferably coupled between the power and ground loops as discussed in more detail below to reduce EMI generated by an integrated circuit in the cavity. While the preferred embodiment couples the filter capacitors between a power line and a ground line, other implementations may advantageously couple the filter capacitors between different power lines or between a power line and an electrical common line. Further, in an alternative embodiment, the filter capacitors may be provided in the border region as represented by filter capacitor 31. While such an arrangement affords noise reduction, it may entail the formation of vias for connection between the surface mounted capacitor and the buried power and ground conductors.

Referring to Fig. 2, a plan view of conductors in cavity 20 of ball grid array 10 of Fig. 1 in accordance with the present invention is shown. A plurality of contact pads 32 are provided adjacent die mounting region 22. The pads of an integrated circuit to be mounted in region 22 are connected to the contact pads often by low-inductance flip-mounting or by other known techniques. Some of conductive traces 24 are connected between contact pads 32 and contact pads 36 which are connected to the internal conductors of ball grid array 10 (as discussed above) . Other conductive traces 24 are connected between the power and ground loops and contact pads 32. Due to the high number of contact pads 32, conductive traces 24 and contact pads 36, only a representative fraction of these components are labeled with their corresponding reference numbers.

A power loop 40 that is coupled to input power line 26 is provided about die mounting region 22. A ground loop 42 that is coupled to input ground line 28 is similarly provided about die mounting region 22.

In the embodiment of Fig. 2, four filter capacitors 30 are connected between the power and ground loops 40,42. These capacitors provide filtering immediately adjacent the integrated circuit thus achieving EMI reduction very close to the source. EMI reduction close to the source is desired because it reduces the propagation of noisy signals to other components and reduces the parasite effects of noise. Furthermore, the arrangement of Fig. 2 permits the filtering capacitors to be directly surface mounted onto the exposed power and ground loops. Surface mounting is preferably achieved with standard surface mount assembly processes and is a convenient and economical manner of mounting the filter capacitors.

In production, the capacitors are preferably mounted prior to the wire bonding formation of conductive traces 24. The capacitors preferably have a capacitance ranging from approximately 0.1 to 0.001 micro Farads and a size designation of 0402.

While Fig. 2 illustrates capacitors 30 at the corners of the die attachment region, it should be recognized that the filters can be placed anywhere therein. Though placement in the corners may be convenient for some applications, a primary objective is to provide filtering close to the integrated circuit to reduce noise. Hence the capacitors could be provided between neighboring conductive traces, in fewer or greater numbers than shown and in other arrangements in which they achieve the filtering of EMI and related noise.

While the invention has been described in connection with specific embodiments thereof, it will be understood that it is capable of further modification, and this application is intended to cover any variations, uses, or adaptations of the invention following, in general, the principles of the invention and including such departures from the present disclosure as come within known or customary practice in the art to which the invention pertains and as may be applied to the essential features hereinbefore set forth, and as fall within the scope of the invention and the limits of the appended claims.

## Claims

1. A low inductance integrated circuit package, comprising:
a platform (12) having a plurality of low inductance mounting conductors (18) formed on a first side thereof;
a cavity (20) formed on a second side of said platform and including a die attachment region (22) ;
a plurality of electrical contacts (32) formed in said cavity proximate said die attachment region for receiving the pads of an integrated circuit mounted at said die attachment region, at least some of said electrical contacts being coupled by conductors in said platform to some of said mounting conductors;
a power line (40) coupled to at least one of said electrical contacts;
a ground line (42) coupled to at least another of said electrical contacts; and
means (30) provided on said second side of said platform and coupled to at least one of said power and ground lines (40,42) for reducing EMI generated by an integrated circuit mounted at said die attachment region (22).

2. The integrated circuit package of claim 1, wherein said EMI reducing means (30) is coupled to the other of said power and ground lines (40,42).

3. The integrated circuit package of claim 1, wherein said EMI reducing means (30) is coupled between said power and ground lines (40,42).

4. The integrated circuit package of claim 3, wherein said EMI reducing means (30) is provided within said cavity (20).

5. The integrated circuit package of claim 1, further comprising a border region (14) formed on said platform about said cavity (12) and wherein said EMI reducing means (30) is provided in said border region.

6. The integrated circuit package of claim 1, wherein said low inductance mounting conductors are conductive balls (18).

7. The integrated circuit package of claim 1, wherein said EMI reducing means includes a filter capacitor (30).

8. The integrated circuit package of claim 1, wherein said power and ground lines (40,42) each respectively include a power line loop and a ground line loop that encircle said die attachment region.

9. The integrated circuit package of claim 8, wherein said EMI reducing means includes a plurality of filter capacitors (30) each coupled between the power and ground loops.

10. The integrated circuit package of claim 9, wherein said plurality of filter capacitors (30) are surface mounted to said power and ground loops (40,42).
